# EUROPÄISCHE PATENTSCHRIFT

(11) **EP 2 149 281 B1**
(45) Veröffentlichungstag und Bekanntmachung des Hinweises auf die Patenterteilung: **27.06.2012**
(21) Anmeldenummer: 07729402.3
(22) Anmeldetag: 22.05.2007
(51) Int. Cl.: H05B 33/08, H05K 1/00, H05K 1/18

(54) **LEUCHTVORRICHTUNG UND PROJEKTIONSVORRICHTUNG MIT EINER DERARTIGEN LEUCHTVORRICHTUNG**
ILLUMINATION DEVICE AND PROJECTION DEVICE WITH SUCH AN ILLUMINATION DEVICE
DISPOSITIF D'ÉCLAIRAGE ET DISPOSITIF DE PROJECTION POURVU D'UN TEL DISPOSITIF D'ÉCLAIRAGE

(43) Veröffentlichungstag der Anmeldung: 03.02.2010
(73) Patentinhaber: OSRAM AG, 81536 München (DE)
(72) Erfinder: HUBER, Andreas, 82216 Maisach (DE); HYING, Ralf, 81827 München (DE); NIEDERMEIER, Peter, 80995 München (DE)
(86) Internationale Anmeldenummer: PCT/EP2007/054963
(87) Internationale Veröffentlichungsnummer: WO 2008/141674

(56) Entgegenhaltungen:
- EP-A- 1 691 583
- EP-A- 1 768 470
- DE-U1- 20 319 650
- US-A1- 2002 187 803

## Beschreibung

### Technisches Gebiet

Die Erfindung betrifft eine Leuchtvorrichtung sowie eine Projektionsvorrichtung mit einer derartigen Leuchtvorrichtung.

### Stand der Technik

Hochleistungsleuchtdioden zum Betrieb im Amperebereich sind erst seit kurzem bekannt. Diese benötigen eine entsprechende Ansteuerung über eine Leistungselektronik. Die elektrische Verbindung zwischen einer Leistungselektronik und einer Hochleistungsleuchtdiode wird bei bekannten Systemen durch verdrillte Leitungen realisiert. Dies stellt jedoch nur eine suboptimale Lösung im Hinblick auf hohe Betriebsfunktionalität und Betriebssicherheit dar.

Aus der DE 203 19 650 U1 ist ein Leuchtdiodenarray bekannt, welches aus einer flexiblen Leiterplatte mit darauf angebrachten Leuchtdioden besteht. Die flexible Leiterplatte ist über 2 Kabel an den Treiber angeschlossen. Die Kabel weisen allerdings einen hohen Induktivitätsbelag auf.

Aus der EP 1 768 470 A1 ist eine Methode zum Verbinden zweier fester Leiterplatten bekannt, die über eine flexible Leiterplatte mit darauf angebrachten Leiterbahnen erfolgt. Die flexible Leiterplatte ist dabei unternnbar mit den festen Leiterplatten durch den Laminationsprozeß der Leiterplatten verbunden.

### Darstellung der Erfindung

Es ist Aufgabe der vorliegenden Erfindung, eine Leuchtvorrichtung zu schaffen, mit welcher eine hohe Betriebssicherheit eines Leuchtdioden-Moduls ermöglicht und dies möglichst aufwandsarm und kostengünstig erreicht werden kann.

Diese Aufgabe wird durch eine Leuchtvorrichtung, welche die Merkmale nach Anspruch 1 aufweist, gelöst.

Eine erfindungsgemäße Leuchtvorrichtung umfasst ein Leistungselektronik-Modul und zumindest ein Leuchtdioden-Modul. Das Leistungselektronik-Modul ist mit dem Leuchtdioden-Modul mittels einer Flexleiterplatte elektrisch verbunden. Eine derartige Realisierung einer Verbindungsleitung in Form einer Flexleiterplatte ermöglicht höchste Betriebssicherheit. Darüber hinaus kann dadurch die Ansteuerung von Hochleistungsleuchtdioden mit äußerst schnellen Ansteuersignalen im Frequenzbereich ab 100 kHz erreicht werden.

Vorzugsweise ist das Leuchtdioden-Modul zum Betrieb mit elektrischen Strömen im Amperebereich ausgebildet. Insbesondere ist vorgesehen, dass das Leuchtdioden-Modul zumindest einen Leuchtdioden-Chip mit mehreren Leuchtdioden aufweist, und ein Leuchtdioden-Chip zum Betrieb mit elektrischen Strömen größer oder gleich 1 A, insbesondere bis zu 6 A, ausgebildet ist. Bevorzugt weist ein Leuchtdioden-Chip eine Flächengröße von etwa 1 mm² oder aber auch mehr auf.

Insbesondere kann vorgesehen sein, dass ein Leuchtdioden-Modul zumindest zwei Leuchtdioden-Chips umfasst. Dadurch entstehen Betriebsströme im zweistelligen Amperebereich. Durch die Flexleiterplatte als Verbindungsleitung kann auch bei derartigen elektrischen Strömen eine einfach konzipierte niederohmige und niedrig induktive Verbindung zwischen dem Leistungselektronik-Modul und den Hochleistungsleuchtdioden hergestellt werden.

Hierdurch sind vollständig andere Frequenzbereiche und auch elektrische Ströme beispielsweise im Vergleich zur Hochfrequenztechnik vorgesehen.

Vorzugsweise sind Leiterbahnen zur Signalübertragung zwischen dem Leistungselektronik-Modul und dem Leuchtdioden-Modul und somit zum Übertragen der elektrischen Ströme auf der Oberseite und der Unterseite der Flexleiterplatte ausgebildet. Vorzugsweise sind somit die Leiterbahnen auf gegenüberliegenden Seiten des Trägermaterials bzw. der Trägerplatte der Flexleiterplatte vorgesehen.

Vorzugsweise weist das Trägermaterial der Flexleiterplatte eine Dicke größer 30 µm, insbesondere 50 µm, auf.

Das Trägermaterial der Flexleiterplatte kann Polyimid umfassen oder FR4 sein. Es kann jedoch auch vorgesehen sein, dass das Trägermaterial der Flexleiterplatte ein einfaches Isolierband mit entsprechender Dicke ist. Auf diesem Isolierband können dann vorzugsweise auf den gegenüberliegenden Seiten und somit auf der Unterseite und der Oberseite Kupferbahnen oder Kupferplatten als Leiterbahnen ausgebildet sein.

Auch bei einer Ausgestaltung des Trägermaterials als Polyimid können auf der Oberseite und der Unterseite Kupferplatten als Leiterbahnen angeordnet sein.

Insbesondere bei einer Anbringung der Leiterbahnen auf der Oberseite und der Unterseite des Trägermaterials der Flexleiterplatte ist es vorgesehen, die Flexleiterplatte so auszubilden, dass sie zur Übertragung von Signalen mit Rise- und Fall-Zeiten kleiner oder gleich 15 µs, insbesondere kleiner oder gleich 10 µs ausgebildet ist.

Insbesondere schnelle Ansteuerungen des Leuchtdioden-Moduls mit Zeitdauern unter 3 µs können dadurch realisiert werden.

Vorzugsweise sind die Leiterbahnen der Flexleiterplatte mit einem Lötstopplack oder einem Isolierband bedeckt.

Es kann vorgesehen sein, dass das Leuchtdioden-Modul lösbar mit der Flexleiterplatte verbunden ist. Unter einer lösbaren Verbindung wird eine zerstörungsfreie und reversible Verbindungs- und Trennungsmöglichkeit verstanden. Insbesondere kann vorgesehen sein, dass an der Flexleiterplatte Stecker, insbesondere Flachstecker, angeordnet sind, mittels welchen eine lösbare Steckverbindung mit dem Leuchtdioden-Modul ausgebildet ist. Als Verbindungsstecker können beispielsweise Flachstecker mit 6,3 mm verwendet werden.

Es kann vorgesehen sein, dass die Stecker, insbesondere die Flachstecker, mit zusätzlicher Betätigung einer Rastnase ausgeführt sind, wodurch dann das Leuchtdioden-Modul quasi kraftlos angeschlossen werden kann.

Dadurch kann der Verschleiß oder die Beschädigung von Komponenten der Leuchtvorrichtung verhindert werden.

Insbesondere ist vorgesehen, dass die Stecker der Flexleiterplatte auf einer Seite der Flexleiterplatte angeordnet sind und die an der gegenüberliegenden Seite der Flexleiterplatte ausgebildete Leiterbahn durch zumindest eine Durchkontaktierung durch das Trägermaterial mit dem zugeordneten Stecker elektrisch kontaktierbar ist.

Das Leuchtdioden-Modul kann mit der Flexleiterplatte auch fest verbunden sein. Eine derartige unlösbare Verbindung kann beispielsweise durch ein Verlöten des Leuchtdioden-Moduls mit der Flexleiterplatte realisiert sein.

Dadurch kann eine dauerhafte elektrische und mechanische Verbindung geschaffen werden, bei welcher ein unerwünschtes Lösen verhindert werden kann.

Die Flexleiterplatte ist erfindungsgemäß in einem Schlitz der Platine des Leistungselektronik-Moduls eingesteckt.

Insbesondere ist vorgesehen, dass die Flexleiterplatte dann in dem eingesteckten Zustand in die Platine des Leistungselektronik-Moduls zusätzlich verlötet ist. Dadurch kann ein Herausfallen oder ein unerwünschtes Verrutschen und somit ein Beeinträchtigen der elektrischen Kontaktierung verhindert werden.

Der Vorteil der Ausgestaltung der Leuchtvorrichtung mit der Flexleiterplatte ist insbesondere unter anderem in der niedrigen Induktivität, also auch der Möglichkeit des niedrigen Widerstands zu sehen. Darüber hinaus kann eine solche Verbindungsvariante einfach hergestellt werden und damit kostengünstig realisiert werden.

Stecker auf der Flexleiterplatte können als Hochstromstecker sowohl als PIH als auch als SMD direkt auf dem Kupfermaterial einer Leiterbahn angelötet sein. Die Dicke der Leiterbahnen können insbesondere Werte von 35 µm, 70 µm oder 105 µm aufweisen.

Ein weiterer Aspekt der Erfindung betrifft eine Projektionsvorrichtung mit einer Anzeigeeinheit und einer erfindungsgemäßen Leuchtvorrichtung oder einer vorteilhaften Ausgestaltung davon. Die Leuchtvorrichtung ist so angeordnet, dass sie zur Beleuchtung der Anzeigeeinheit positioniert ist. Insbesondere kann somit eine Projektionsvorrichtung mit Hochleistungsleuchtdioden realisiert werden. Eine Projektionsvorrichtung kann beispielsweise als Rückprojektionsfernsehgerät (RPTV) ausgebildet sein. Auch andere Projektoren können mit einer erfindungsgemäßen Leuchtvorrichtung ausgerüstet werden.

### Kurze Beschreibung der Zeichnungen

Ausführungsbeispiele der Erfindung werden nachfolgend anhand schematischer Zeichnungen erläutert. Es zeigen:
- Fig. 1: eine Schnittdarstellung durch eine Flexleiterplatte einer erfindungsgemäßen Leuchtvorrichtung;
- Fig. 2: eine Schnittdarstellung durch eine Flexleiterplatte und einem Leuchtdioden-Modul einer erfindungsgemäßen Leuchtvorrichtung;
- Fig. 3: eine Draufsicht auf eine weitere Ausführung einer Flexleiterplatte einer erfindungsgemäßen Leuchtvorrichtung; und
- Fig. 4: eine schematische Schnittdarstellung eines Ausführungsbeispiels einer erfindungsgemäßen Leuchtvorrichtung.

### Bevorzugte Ausführung der Erfindung

In den Figuren werden gleiche oder funktionsgleiche Elemente mit den gleichen Bezugszeichen versehen.

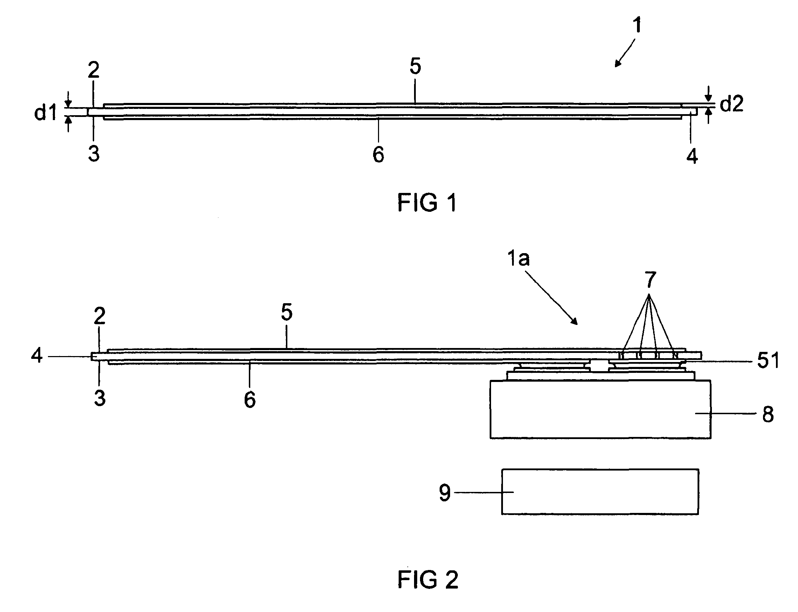

In Fig. 1 ist in einer schematischen Schnittdarstellung eine Flexleiterplatte 1 gezeigt, welche ein elektrisch isolierendes Trägermaterial 4 aufweist, welches plattenartig ausgebildet ist. Auf einer Oberseite 2 des Trägermaterials 4 ist eine erste Leiterbahn 5 und auf einer Unterseite 3 des Trägermaterials 4 ist eine zweite Leiterbahn 6 ausgebildet. Die Leiterbahnen 5 und 6 sind vorzugsweise als Kupferplatten ausgebildet.

Das Trägermaterial 4 kann Polyimid sein. Ebenso kann vorgesehen sein, dass das Trägermaterial 4 ein einfaches herkömmliches Isolierband ist. Die Leiterbahnen 5 und 6 können jeweils mit einem Lötstopplack oder einem Isolierband bedeckt sein. Die Dicke d1 des Trägermaterials 4 beträgt im Ausführungsbeispiel etwa 50 µm. Die Dicke d2 einer Leiterbahn 5 kann beispielsweise 35 µm betragen. Ebenso kann vorgesehen sein, dass die Dicke d2 beispielsweise 70 µm oder 105 µm beträgt.

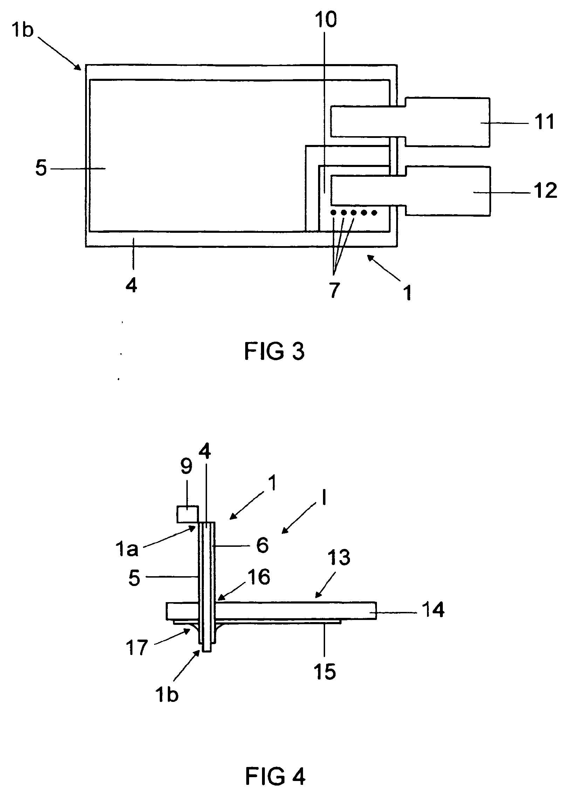

In Fig. 2 ist in einer schematischen Schnittdarstellung eine weitere Ausführung von Teilkomponenten einer erfindungsgemäßen Leuchtvorrichtung I (Fig. 4) gezeigt. An einem ersten Ende la der Flexleiterplatte 1 sind Durchkontaktierungen 7 durch das Trägermaterial 4 ausgebildet, durch welche eine elektrische Verbindung zwischen der ersten Leiterbahn 5 auf der Oberseite 2 und einem Leiterbahnteil 51 auf der Unterseite 3 realisiert ist. Das Leiterbahnteil 51 ist der ersten Leiterbahn 5 zugeordnet und kontaktlos mit der zweiten Leiterbahn 6 an der Unterseite 3 ausgebildet. Ein blockartiges Kupferelement 8 ist auf der der Unterseite 3 zugewandten Seite mit der zweiten Leiterbahn 6 und dem Leiterbahnteil 51 der ersten Leiterbahn 5 elektrisch kontaktiert. Ein Leuchtdioden-Modul 9 kann mit diesem Kupferelement 8 fest verbunden werden, indem es beispielsweise an das Kupferelement 8 angelötet ist. In Fig. 2 ist der separiert Zustand und somit der nicht befestigten Zustand des Leuchtdioden-Moduls 9 an dem Kupferelement 8 gezeigt.

In Fig. 3 ist eine Draufsicht auf eine weitere Ausführungsform einer Flexleiterplatte 1 gezeigt. Bei dieser Draufsicht ist die plattenförmige Ausgestaltung der ersten Leiterbahn 5 zu erkennen. Darüber hinaus ist auch ein dem Leiterbahnteil 51 entsprechender Leiterbahnteil 10 gezeigt, welcher durch Durchkontaktierungen 7' mit der an der Unterseite 3 angeordneten zweiten Leiterbahn 6 elektrisch kontaktiert ist. Sowohl mit der ersten Leiterbahn 5 als auch mit der zweiten Leiterbahn 6 über das Leiterbahnteil 10 ist jeweils ein Flachstecker 11 und 12 elektrisch verbunden. Der Flachstecker 11 ist mit der ersten Leiterbahn 5 verlötet. Des Weiteren ist der zweite Flachstecker 12 mit dem Leiterbahnteil 10 verlötet. Beide Flachstecker 11 und 12 sind als Flachstecker mit 6,3 mm ausgebildet.

Des Weiteren sind beide Flachstecker 11 und 12 auf einer Seite, insbesondere auf der Oberseite 2, des Trägermaterials 4 fest positioniert.

In Fig. 4 ist in einer schematischen Schnittdarstellung ein Ausführungsbeispiel einer Leuchtvorrichtung I gezeigt. Die Leuchtvorrichtung I umfasst eine Flexleiterplatte 1, welche gemäß den Ausführungen in Fig. 1 bis Fig. 3 realisiert sein kann.

Darüber hinaus umfasst die Leuchtvorrichtung I zumindest ein Leuchtdioden-Modul 9. Das Leuchtdioden-Modul 9 umfasst zumindest einen Leuchtdioden-Chip, welcher beispielsweise eine Fläche von 1 mm² aufweisen kann. Das Leuchtdioden-Modul 9 ist als Hochleistungs-Modul ausgebildet und zum Betrieb mit elektrischen Strömen im Amperebereich vorgesehen. Im Ausführungsbeispiel ist insbesondere vorgesehen, dass jeder Leuchtdioden-Chip eines Leuchtdioden-Moduls 9 zum Betrieb mit elektrischen Strömen von bis zu 6 A ausgebildet ist. Insbesondere kann vorgesehen sein, dass das Leuchtdioden-Modul 9 sechs derartiger Leuchtdioden-Chips umfasst.

Darüber hinaus umfasst die Leuchtvorrichtung I ein Leistungselektronik-Modul 13, welches eine Platine 14 aufweist, auf der die Leistungselektronikbauteile angeordnet sind. Darüber hinaus ist im Ausführungsbeispiel an der Unterseite der Platine 14 zumindest eine Leiterbahn 15 ausgebildet, welche mit den Leiterbahnen 5 und 6 der Flexleiterplatte 1 elektrisch kontaktiert sind. Dazu ist im Ausführungsbeispiel vorgesehen, dass die Flexleiterplatte 1 durch einen Schlitz 16 in der Platine 14 hindurchgesteckt ist und auf der Unterseite durch eine Lötverbindung 17 fest positioniert ist. Durch die Verlötung 17 ist die elektrische Kontaktierung zwischen der Leiterbahn 15 und den Leiterbahnen 5 und 6 hergestellt. Wie zu erkennen ist, ist die Flexleiterplatte 1 mit einem zweiten Ende 1b durch den Schlitz 16 vollständig hindurchgesteckt.

Durch eine derartige Ausgestaltung einer Leuchtvorrichtung I kann die Ansteuerung von Hochleistungsleuchtdioden mit schnellen Ansteuersignalen unter 3 µs im höheren Frequenzbereich ab 100 kHz ermöglicht werden.

Die Flexleiterplatte 1 ist zur Übertragung von Signalen mit Rise- und Fall-Zeiten kleiner 10 µs ausgebildet.

Insbesondere ist vorgesehen, dass eine Leuchtvorrichtung I in einer Projektionsvorrichtung angeordnet ist und zur Beleuchtung einer Anzeigeeinheit der Projektionsvorrichtung positioniert ist.

## Patentansprüche

1. Leuchtvorrichtung mit einem Leistungselektronik-Modul (13) und einem Leuchtdioden-Modul (9), welches mittels einer Flexleiterplatte (1) mit dem Leistungselektronik-Modul (13) elektrisch verbunden ist,
**dadurch gekennzeichnet, dass**
die Flexleiterplatte (1) in einen Schlitz (16) der Platine (14) des Leistungselektronik-Moduls (13) eingesteckt ist.

2. Leuchtvorrichtung nach Anspruch 1,
**dadurch gekennzeichnet, dass**
das Leuchtdioden-Modul (9) zum Betrieb mit elektrischen Strömen im Amperebereich ausgebildet ist.

3. Leuchtvorrichtung nach Anspruch 1 oder 2,
**dadurch gekennzeichnet, dass**
das Leuchtdioden-Modul (9) zumindest einen Leuchtdioden-Chip mit mehreren Leuchtdioden aufweist und der Leuchtdioden-Chip zum Betrieb mit elektrischen Strömen größer oder gleich 1 A, insbesondere 6 A, ausgebildet ist.

4. Leuchtvorrichtung nach einem der vorhergehenden Ansprüche,
**dadurch gekennzeichnet, dass**
Leiterbahnen (5, 6) zur Signalübertragung zwischen dem Leistungselektronik-Modul (13) und dem Leuchtdioden-Modul (9) auf der Oberseite (2) und der Unterseite (3) der Flexleiterplatte (1) ausgebildet sind.

5. Leuchtvorrichtung nach einem der vorhergehenden Ansprüche,
**dadurch gekennzeichnet, dass**
das Trägermaterial (4) der Flexleiterplatte (1) eine Dicke (dl) größer 30 µm, insbesondere 50 µm, aufweist.

6. Leuchtvorrichtung nach einem der vorhergehenden Ansprüche,
**dadurch gekennzeichnet, dass**
die Flexleiterplatte (1) zur Übertragung von Signalen mit Rise- und Fall-Zeiten kleiner oder gleich 15 µs, insbesondere kleiner oder gleich 10 µs, ausgebildet ist.

7. Leuchtvorrichtung nach einem der vorhergehenden Ansprüche,
**dadurch gekennzeichnet, dass**
das Trägermaterial (4) der Flexleiterplatte (1) Polyimid umfasst.

8. Leuchtvorrichtung nach einem der vorhergehenden Ansprüche,
**dadurch gekennzeichnet, dass**
das Trägermaterial (4) der Flexleiterplatte (1) ein Isolierband ist.

9. Leuchtvorrichtung nach einem der vorhergehenden Ansprüche,
**dadurch gekennzeichnet, dass**
die Leiterbahnen (5, 6) der Flexleiterplatte (1) mit einem Lötstopplack oder einem Isolierband bedeckt sind.

10. Leuchtvorrichtung nach einem der vorhergehenden Ansprüche,
**dadurch gekennzeichnet, dass**
das Leuchtdioden-Modul (9) lösbar mit der Flexleiterplatte (1) verbunden ist.

11. Leuchtvorrichtung nach Anspruch 10,
**dadurch gekennzeichnet, dass**
an der Flexleiterplatte (1) Stecker (11, 12), insbesondere Flachstecker, angeordnet sind, mittels welchen eine lösbare Steckverbindung mit dem Leuchtdioden-Modul (9) ausgebildet ist.

12. Leuchtvorrichtung nach Anspruch 11,
**dadurch gekennzeichnet, dass**
die Stecker (11, 12) auf einer Seite der Flexleiterplatte (1) angeordnet sind und die an der gegenüberliegenden Seite der Flexleiterplatte (1) ausgebildete Leiterbahn (5, 6) durch zumindest eine Durchkontaktierung (7, 7') durch das Trägermaterial (4) mit dem zugeordneten Stecker (11, 12) kontaktiert ist.

13. Leuchtvorrichtung nach einem der vorhergehenden Ansprüche,
**dadurch gekennzeichnet, dass**
das Leuchtdioden-Modul (9) mit der Flexleiterplatte (1) fest verbunden ist, insbesondere verlötet ist.

14. Projektionsvorrichtung mit einer Anzeigeeinheit und einer Leuchtvorrichtung (I) nach einem der vorhergehenden Ansprüche, welche zur Beleuchtung der Anzeigeeinheit angeordnet ist.

## Claims

1. Illumination device with a power electronics module (13) and a light-emitting diode module (9), which is electrically connected to the power electronics module (13) by means of a flexible printed circuit board (1), **characterized in that** the flexible printed circuit board (1) is plugged into a slot (16) in the circuit board (14) of the power electronics module (13).

2. Illumination device according to Claim 1, **characterized in that** the light-emitting diode module (9) is designed for operation with electrical currents in the ampere range.

3. Illumination device according to Claim 1 or 2, **characterized in that** the light-emitting diode module (9) has at least one light-emitting diode chip with a plurality of light-emitting diodes, and the light-emitting diode chip is designed for operation with electrical currents of greater than or equal to 1 A, in particular 6 A.

4. Illumination device according to one of the preceding claims, **characterized in that** conductor tracks (5, 6) for signal transmission between the power electronics module (13) and the light-emitting diode module (9) are formed on the upper side (2) and the lower side (3) of the flexible printed circuit board (1).

5. Illumination device according to one of the preceding claims, **characterized in that** the carrier material (4) of the flexible printed circuit board (1) has a thickness (dl) of greater than 30 µm, in particular 50 µm.

6. Illumination device according to one of the preceding claims, **characterized in that** the flexible printed circuit board (1) is designed for transmission of signals with rise and fall times of less than or equal to 15 µs, in particular less than or equal to 10 µs.

7. Illumination device according to one of the preceding claims, **characterized in that** the carrier material (4) of the flexible printed circuit board (1) comprises polyimide.

8. Illumination device according to one of the preceding claims, **characterized in that** the carrier material (4) of the flexible printed circuit board (1) is an insulating tape.

9. Illumination device according to one of the preceding claims, **characterized in that** the conductor tracks (5, 6) of the flexible printed circuit board (1) are covered with a solder resist or insulating tape.

10. Illumination device according to one of the preceding claims, **characterized in that** the light-emitting diode module (9) is releasably connected to the flexible printed circuit board (1).

11. Illumination device according to Claim 10, **characterized in that** plugs (11, 12), in particular flat plugs, are arranged on the flexible printed circuit board (1), by means of which plugs a releasable plug-type connection with the light-emitting diode module (9) is formed.

12. Illumination device according to Claim 11, **characterized in that** the plugs (11, 12) are arranged on one side of the flexible printed circuit board (1), and contact is made between the conductor track (5, 6), which is formed on the opposite side of the flexible printed circuit board (1), and the associated plug (11, 12) by at least one throughplating (7, 7') through the carrier material (4).

13. Illumination device according to one of the preceding claims, **characterized in that** the light-emitting diode module (9) is permanently connected, in particular soldered, to the flexible printed circuit board (1).

14. Projection device with a display unit and an illumination device (I) according to one of the preceding claims, which illumination device is arranged so as to illuminate the display unit.

## Revendications

1. Dispositif d'éclairage pourvu d'un module électronique de puissance (13) et d'un module à diodes électroluminescentes (9) relié électriquement au module électronique de puissance (13) par une carte de circuit imprimé flexible (1),
**caractérisé en ce que**
la carte de circuit imprimé flexible (1) est insérée dans une fente (16) de la platine (14) du module électronique de puissance (13).

2. Dispositif d'éclairage selon la revendication 1,
**caractérisé en ce que**
le module à diodes électroluminescentes (9) est conçu pour fonctionner avec des courants électriques dans la plage de l'ampère.

3. Dispositif d'éclairage selon la revendication 1 ou 2,
**caractérisé en ce que**
le module à diodes électroluminescentes (9) comporte au moins une puce LED avec plusieurs diodes électroluminescentes et **en ce que** la puce LED est conçue pour fonctionner avec des courants électriques supérieurs ou égaux à 1 A, en particulier 6 A.

4. Dispositif d'éclairage selon l'une des revendications précédentes,
**caractérisé en ce que**
des pistes conductrices (5, 6) pour la transmission des signaux entre le module électronique de puissance (13) et le module à diodes électroluminescentes (9) sont réalisées sur la face supérieure (2) et la face inférieure (3) de la carte de circuit imprimé flexible (1).

5. Dispositif d'éclairage selon l'une des revendications précédentes,
**caractérisé en ce que**
le support (4) de la carte de circuit imprimé flexible (1) a une épaisseur (dl) supérieure à 30 µm, en particulier 50 µm.

6. Dispositif d'éclairage selon l'une des revendications précédentes,
**caractérisé en ce que**
la carte de circuit imprimé flexible (1) est conçue pour la transmission de signaux ayant des temps de montée et de descente inférieurs ou égaux à 15 µs, en particulier inférieurs ou égaux à 10 µs.

7. Dispositif d'éclairage selon l'une des revendications précédentes,
**caractérisé en ce que**
le support (4) de la carte de circuit imprimé flexible (1) comprend du polyimide.

8. Dispositif d'éclairage selon l'une des revendications précédentes,
**caractérisé en ce que**
le support (4) de la carte de circuit imprimé flexible (1) est un ruban isolant.

9. Dispositif d'éclairage selon l'une des revendications précédentes,
**caractérisé en ce que**
les pistes conductrices (5, 6) de la carte de circuit imprimé flexible (1) sont recouvertes d'un vernis de préserve de soudure ou d'un ruban isolant.

10. Dispositif d'éclairage selon l'une des revendications précédentes,
**caractérisé en ce que**
le module à diodes électroluminescentes (9) est relié de manière amovible à la carte de circuit imprimé flexible (1).

11. Dispositif d'éclairage selon la revendication 10,
**caractérisé en ce que**
des fiches (11, 12) sont disposées sur la carte de circuit imprimé flexible (1), en particulier des fiches plates, au moyen desquelles une connexion enfichable amovible est formée avec le module à diodes électroluminescentes (9).

12. Dispositif d'éclairage selon la revendication 11,
**caractérisé en ce que**
les fiches (11, 12) sont disposées sur une des faces de la carte de circuit imprimé flexible (1) et **en ce que** la piste conductrice (5, 6) réalisée sur la face opposée de la carte de circuit imprimé flexible (1) est en contact avec la fiche associée (11, 12) à travers au moins un trou métallisée (7, 7').

13. Dispositif d'éclairage selon l'une des revendications précédentes,
**caractérisé en ce que**
le module à diodes électroluminescentes (9) est solidaire de la carte de circuit imprimé flexible (1), en particulier soudé sur celle-ci.

14. Dispositif de projection pourvu d'une unité d'affichage et d'un dispositif d'éclairage (I) selon l'une des revendications précédentes, lequel est agencé pour éclairer l'unité d'affichage.
